# EUROPEAN PATENT APPLICATION

(11) **EP 2 365 519 A1**
(43) Date of publication of application: **14.09.2011**
(21) Application number: 10155907.8
(22) Date of filing: 09.03.2010
(51) Int. Cl.: H01L 21/58, H01L 23/495

(54) **Semiconductor Die Package**

(71) Applicant: NXP B.V., 5656 AG Eindhoven (NL)
(72) Inventor: Offermann, Bernd, 5656 AG, Eindhoven (NL)
(74) Representative: Krott, Michel

(57) **Abstract**

A die package, comprising:
a die (105) having a lower surface; and
a diepad (111) having a body portion and an island portion extending outward from the body portion, the island portion having a top surface,
wherein the lower surface of the die faces and is joined to the top surface of the diepad (111).

## Description

### FIELD OF THE INVENTION

This invention relates generally to semiconductor die packages in which certain components are held together by adhesive.

### BACKGROUND OF THE INVENTION

For reasons of economy and fabricational convenience, semiconductor devices often are constructed by joining multiple components together in die packages.

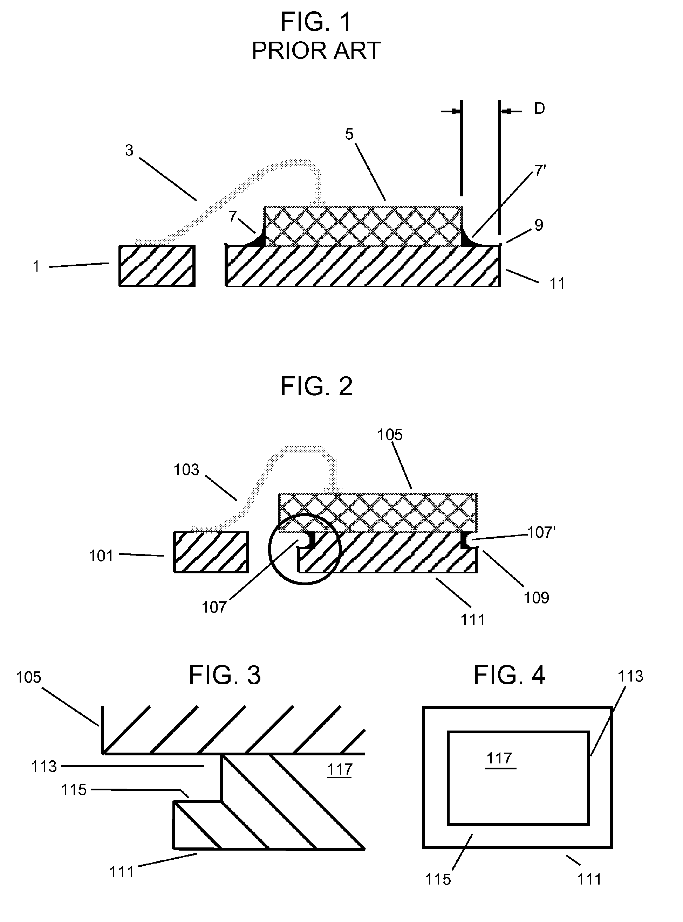

As shown in Fig. 1, a semiconductor die package has a die pad 11 which supports a die 5 (the die 5 includes a semiconductor device which is fabricated in a known manner). Electrical signals are transmitted to and from the die via wires 3 (only one wire is shown, to avoid unnecessarily complicating the drawing). Each wire 3 is secured to a wedgepad 1, and external electrical connections are made to the portion of the wire 3 supported by the wedgepad 1. This avoids stressing directly the electrical components (not shown) on the die 5.

For reasons of scale and economy, a diepad is preferably fabricated using bulk manufacturing techniques, in which multiple identical or different dies are formed from a suitable substrate material. The individual dies are separated from the substrate using a saw to cut the substrate to size, or by stamping. The cutting or stamping operation typically leaves each diepad 11 with one or more burrs 9, which are typically 5-10 µm high. Seen from the side, diepad 11 is typically rectangular in cross-section.

The die 5 is then joined to the diepad 11 by adhesive material applied between then die 5 and the diepad 11. The die 5 is placed above the diepad 11 with a predetermined quantity of adhesive therebetween, and the die 5 and diepad 11 are brought together. To insure the die 5 is well-secured to the diepad 11, the quantity of adhesive used is sufficient so that all of the region between the die 5 and diepad 11 is filled with the adhesive. Excess adhesive 7, 7' squeezes out between the die 5 and diepad 11. To capture the excess adhesive 7, 7' and insure it does not flow down along the edge of the diepad 11 to the diepad's back surface, the diepad 11 is made larger than the die 5 so that the edge of the diepad 11 extends out past the edge of the die 5 by a distance D, which is typically 100-200 µm. This clearance also is provided for die positioning tolerance, in case the die 5 is offset relative to the diepad 11; that way, even if the die 5 is offset laterally relative to diepad 11, the edge of the die 5 does not project beyond the edge of the diepad 11 unsupported.

The presence of burr 9 complicates manufacturing because it prevents the die 5 from being positioned horizontally at a location offset from the diepad 11, lowered vertically until the bottom of the die 5 is just higher than the top of the diepad 11, and then shifted horizontally until the die 5 is over the diepad, since in doing so the die 5 would strike the burr 9 and possibly cause the die 5 to be shifted or damaged.

Also, it is undesirable to require the diepad 11 to be larger than the die 5, since that limits the size of the die 5 that can be mounted on a given diepad 11. Die package size can be a concern in space-sensitive applications, such as sensor assemblies, especially sensor assemblies such as those which are used in automobile wheel speed sensors. In such wheel speed sensors, there is a trend to employ so-called in-bearing sensors, which require the miniaturization of the sensors. In-bearing means that the sensor is integrated into the magnetized bearing of the wheel, rather than being attached to the axle shaft in front of a large encoder wheel.

U.S. patent no. 6,927,479 teaches a die package in which a bottom die pad supports and is joined to a smaller spacer by adhesive there between. The smaller spacer in turn supports and is joined to a large overhanging die by adhesive therebetween, so that the large overhanging die is separated from the bottom die pad by the smaller spacer. Electrical wires are bonded to the large overhanging die. However, this arrangement complicates die package fabrication due to the need for the interposed spacer, and formation of two separate adhesive layers. Also, since the bottom die pad extends outward beyond the smaller spacer, the attachment of the smaller spacer to the bottom die pad suffers from the same shortcomings as are discussed above in connection with Fig. 1.

The presence of adhesive causes problems which assembling die packages in known manner; the adhesive limits how the die packages can be assembled, and arrangements must be made to accommodate any excess adhesive which may be present without unduly affecting manufacturing tolerances and procedures.

Accordingly, there is a need for a die and diepad construction that allow for the easy and simple assembly of compact die packages.

There is also a need for a die and diepad construction which better handles any excess adhesive that results from the die package assembly procedure.

### SUMMARY OF THE INVENTION

An aspect of the invention involves a diepad for use in a die package, the diepad being shaped so that one side of the die has a projecting island portion defined at least in part by a recess.

Another aspect of this invention concerns a diepad for use in a die package. The diepad has an upper region, and the upper region has a recess that extends around at least a portion of the upper region.

In both of these instances, the recess can be formed at least in part by first and second wall portions of the diepad. The recess can extend around all of the projecting island portion / upper region.

Yet another aspect of this invention pertains to a die package with a die having a lower surface, and a diepad having a body portion and an island portion extending outward from the body portion, the island portion having a top surface. The lower surface of the die faces and is joined to the top surface of the diepad.

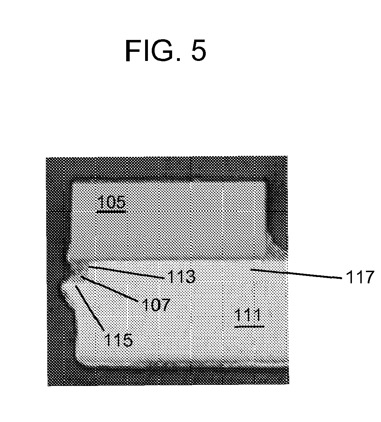

The die package's the island portion can be defined by a recess extending around at least a portion of a perimeter of an upper region of the body portion. The recess can extend around all of the island portion. The recess can at least in part be defined by horizontal and vertical walls, and those walls can be substantially orthogonal. Seen from above, the island portion can be substantially rectangular. The die and diepad can be joined by adhesive, and the recess can be dimensioned to accommodate any adhesive which flows outward from between the die and the diepad. Also, the recess can be fabricated in such a way that an oblique wall is formed, as shown in Fig. 5

This invention also involves a method of forming a die package by providing a die having a lower surface, providing a diepad having a body portion and an island portion extending outward from the body portion, the island portion having a top surface, placing adhesive between the lower surface of the die and the top surface of the island portion, and bringing the die and the diepad together. At least a portion of excess adhesive gathers in a recess where the island portion meets the body portion of the diepad.

### BRIEF DESCRIPTION OF THE DRAWINGS

FIG. 1 is a side elevational view of a die package in accordance with the prior art;

FIG. 2 is a side elevational view of a die package in accordance with the present invention showing accumulated adhesive;

FIG. 3 is a close-up of the circled region of the die package assembly shown in FIG. 2 without accumulated adhesive;

FIG. 4 is a top plan view of the diepad shown in FIGS. 2 and 3; and

FIG. 5 is a side cross-sectional photograph of a portion of an actual die package formed in accordance with this invention.

### DETAILED DESCRIPTION OF EXEMPLARY EMBODIMENTS

As shown in Figs. 2-4, this invention addresses certain known problems which arise in the fabrication of die packages and does so by changing the shape of the diepad 111 which supports die 105. Whereas a conventional diepad has a substantially rectangular cross-section, this invention alters the shape of the top portion of the diepad 111.

More specifically, as shown in Fig. 3, in this invention the diepad 111 is provided at its top edge with a notch formed by a horizontal wall 115 and a vertical wall 113, which, together, form an inward extending corner.

This configuration is particular clear with regard to Fig. 4, which shows from above a rectangular diepad 111. The perimeter of the diepad 111 has a recess formed by vertical wall 113 and horizontal wall 115; together, these walls create an island 117 rising above the horizontal wall 115.

By shaping the diepad 111 to have a recess, when the die 105 and diepad 111 are jointed together, the die 105 sits on the top face of the diepad 105's island 117. Any adhesive that has been squeezed out from between the die 105 and diepad 111 accumulates in the recess surrounding the island 117, as shown at 107, 107 in Fig. 2.

A further benefit to this arrangement is that if the diepad 111 has a burr 109 created when the diepad is cut or stamped, as shown in Fig. 2, that burr is located at a position separated from the top surface of the island 117 on which the bottom of the die 105 rests. Now, during assembly, the burr 109 cannot interfere with the die 105, even if the bottom of the die 105 is lowered to approximately the level of the top of the island 117 and then shifted horizontally into position.

A recess can be formed in the diepad 111 using any suitable manufacturing technique now known, or hereafter discovered. Fabrication techniques such as coining, precision milling, masking with photoresist and etching (in particular, half etching), laser ablation, electron beam machining could be used.

Fig. 5 is a side cross-sectional view of a die package prepared using this invention. The die pad was formed by coining, and it can be seen that, as a consequence of the coining operation, a portion of the left edge of the die pad, in the area beneath and proximate to the horizontal wall 115, is angled outward somewhat, rather than vertical. One benefit of this arrangement is that the outwardly projecting portion of the left wall of the die extends outward past the left wall of the die 105. Since any foreign object moving from the left toward the die 105 on the right will contact the projecting portion of the die pad before the foreign object contacts the die 105, this projecting portion of the die pad can help prevent the die from unwanted contact. Adhesive 107 accumulates in the recess (comer) defined by the vertical wall 113 and the horizontal wall 115 (optionally, a reduced amount of adhesive could be used, or the adhesive could be removed after application, leaving little or no adhesive visible in a side cross-sectional view).

Among the benefits of this invention are that overhanging dies can be used (as explained above, known dies are made somewhat smaller in size than the diepads). By way of non-limiting example, it is envisioned that, typically, the overhanging portion of the die can be up to approximately 25% of the die's length. Dies that are the same size as the diepads also can be employed.

Although the diepad 111 shown in Figs. 2-4 is depicted as being rectangular in shape, with vertical and horizontal walls, this invention is not limited to such shapes. By way of non-limiting example, as seen from above, a diepad that is hexagonal, square, round or oval in shape could be used. Also by way of nonlimiting example, the vertical and horizontal walls forming the recess need not be planar or orthogonal; they could be curved or sloped. Also, a single curved wall defining a rounded notch could be used. Any shape notch can be employed, provided there is a region which can accommodate excess adhesive that may be squeezed out from between the die and the diepad during assembly. In other words, the walls should provide the diepad with an island portion such that the die, when mounted on the diepad, overhangs a portion of the diepad.

Although the recess shown in Fig. 4 extends around the entire perimeter of the diepad 111, it is possible that only some of the sides of the diepad 111 might have the recess formed thereon. By way of non-limiting example, viewed from above, the diepad 111 in Fig. 4 could be modified to only have recesses on its right and left sides.

By virtue of this invention, since it no longer is necessary to provide the diepad with a border region to capture excess adhesive, diepad size can be reduced, and die packages made more compact. In other words, more compact die packages can be assembled, since now the die package size is determined just by the size of the die.

As an example of a field wherein this invention can be helpful, automotive sensors such as electronic gas or throttle valve position sensors can employ two galvanic separated devices, each being formed on its own die pad, which both oppose the same magnet. It is highly desirable to place those two dies near each other so that there will be only a slight difference in the magnetic field from the magnet to which those sensors are exposed. By way of nonlimiting example, sensors using AMR/GMR/TMR and HALL-effects could be employed, and this invention is not to be limited thereto. By using the present invention in the fabrication of these sensors, package size can be reduced and the two galvanic separated devices can be placed close together, improving performance.

Any die package constructed as outlined above is contemplated; this invention extends to all fields of manufacture and use.

Various exemplary embodiments are described in reference to specific illustrative examples. The illustrative examples are selected to assist a person of ordinary skill in the art to form a clear understanding of, and to practice the various embodiments. However, the scope of systems, structures and devices that may be constructed to have one or more of the embodiments, and the scope of methods that may be implemented according to one or more the embodiment, are in no way to the specific illustrative examples that are presented. On the contrary, as will be readily recognized by persons of ordinary skill in the relevant arts based on this description, many other configurations, arrangements, and methods according to the various embodiments may be implemented.

The present invention has been described with respect to particular embodiments and with reference to certain drawings, but the invention is not limited thereto, but rather, is set forth only by the claims. The drawings described are only schematic and are non-limiting. In the drawings, for illustrative purposes, the size of various elements may be exaggerated and not drawn to a particular scale. Any frequencies discussed herein are exemplary and non-limiting, and it is intended that this invention encompasses inconsequential variations in the relevant tolerances and properties of components and modes of operation thereof. Imperfect practice of the invention is intended to be covered.

Where the term "comprising" is used in the present description and claims, it does not exclude other elements or steps. Where an indefinite or definite article is used when referring to a singular noun, e.g. "a" "an" or "the", this includes a plural of that noun unless something otherwise is specifically stated. Hence, the term "comprising" should not be interpreted as being restricted to the items listed thereafter; it does not exclude other elements or steps, and so the scope of the expression "a device comprising items A and B" should not be limited to devices consisting only of components A and B. This expression signifies that, with respect to the present invention, the only relevant components of the device are A and B.

## Claims

1. A diepad for use in a die package, the diepad being shaped so that one side of the die has a projecting island portion defined at least in part by a recess.

2. A diepad according to claim 1, wherein the recess is formed at least in part by a first wall portion of the diepad and a second wall portion of the diepad.

3. A diepad according to claim 1, wherein the recess extends around all of the projecting island portion.

4. A diepad for use in a die package, the diepad having an upper region, the upper region having a recess that extends around at least a portion of the upper region.

5. A diepad according to claim 4, wherein the recess is formed at least in part by a first wall portion of the diepad and a second wall portion of the diepad.

6. A diepad according to claim 4, wherein the recess extends around all of the upper region.

7. A die package, comprising:
a die having a lower surface; and
a diepad having a body portion and an island portion extending outward from the body portion, the island portion having a top surface,
wherein the lower surface of the die faces and is joined to the top surface of the diepad.

8. A die package according to claim 7, wherein the island portion is defined by a recess extending around at least a portion of a perimeter of an upper region of the body portion.

9. A die package according to claim 7, wherein the recess extends around all of the island portion.

10. A die package according to claim 7, wherein the recess is at least in part defined by a horizontal wall and a vertical wall.

11. A die package according to claim 10, wherein the horizontal wall and the vertical wall are substantially orthogonal.

12. A die package according to claim 7, wherein, seen from above, the island portion is substantially rectangular.

13. A die package according to claim 7, wherein the die and diepad are joined by an adhesive.

14. A die package according to claim 7, wherein the recess is dimensioned to accommodate any of the adhesive which flows outward from between the die and the diepad.

15. A method of forming a die package, comprising:
providing a die having a lower surface;
providing a diepad having a body portion and an island portion extending outward from the body portion, the island portion having a top surface;
placing an adhesive between the lower surface of the die and the top surface of the island portion; and
bringing the die and the diepad together,
wherein at least a portion of an excess of the adhesive gathers in a recess where the island portion meets the body portion of the diepad.
